# EUROPEAN PATENT APPLICATION

(11) **EP 2 723 151 A2**
(43) Date of publication of application: **23.04.2014**
(21) Application number: 13186349.0
(22) Date of filing: 27.09.2013
(51) Int. Cl.: H05K 7/14, H05K 9/00

(54) **Electrical device and method for manufacturing electrical device**

(30) Priority: 19.10.2012 JP 2012232305
(71) Applicant: Omron Corporation, Kyoto-shi, Kyoto 600-8530 (JP)
(72) Inventor: Akamoto, Keigo, Kyoto-shi, Kyoto 600-8530 (JP); Takashiro, Hiroto, Kyoto-shi, Kyoto 600-8530 (JP); Ohashi, Shinsuke, Kyoto-shi, Kyoto 600-8530 (JP); Chuma, Tomohiro, Kyoto-shi, Kyoto 600-8530 (JP)
(74) Representative: Kilian Kilian & Partner

(57) **Abstract**

An electrical device to which power supplied from a power source is input comprises: a casing; a circuit board (140) disposed inside the casing; a first electromagnetic shielding plate (110) configured to electromagnetically shield the circuit board (140) by covering a first portion (201) of the circuit board (140); a second electromagnetic shielding plate (112, 118) configured to electromagnetically shield the circuit board (140) by covering a second portion (202) of the circuit board (140) and be removably attachable to the casing independently of the first electromagnetic shielding plate (110); and an input terminal unit (120, 130) configured to input the power supplied from the power source to the circuit board (140), the input terminal unit (120, 130) being fixed to a front surface of the second electromagnetic shielding plate (112, 118), the front surface of the second electromagnetic shielding plate (112, 118) being a surface facing a front side of the casing.

## Description

### TECHNICAL FIELD

The present invention relates to an electrical device and a method for manufacturing an electrical device.

### BACKGROUND ART

Japanese Unexamined Patent Publication No. 2004-31481 discloses a power conditioner equipped with a plurality of input/output terminal blocks.

Power conditioners are categorized into so-called junction box built-in power conditioners and junction box-unmounted power conditioners. For the junction box built-in power conditioner and the junction box-unmounted power conditioner, it is desired to communalize as many parts as possible.

### SUMMARY

In accordance with one aspect of the present invention, there is provided an electrical device, to which power supplied from a power source is input, including a casing, a circuit board disposed in the casing, a first electromagnetic shielding plate configured to electromagnetically shield the circuit board by covering a first portion of the circuit board, a second electromagnetic shielding plate configured to electromagnetically shield the circuit board by covering second portion of the circuit board and be removably attachable to the casing independently of the first electromagnetic shielding plate, and an input terminal unit configured to input the power supplied from the power source to the circuit board and fixed to a front surface of the second electromagnetic shielding plate, the front surface of the second electromagnetic shielding plate being a surface facing a front side of the casing.

In the electrical device, the first electromagnetic shielding plate may be configured to support the casing by being in contact with an inside surface of the casing. The first electromagnetic shielding plate may be provided between the circuit board and a passageway in which a cable for connecting the power source and the input terminal unit to each other is installed.

The electrical device may further includes a plurality of pairs of connection terminals disposed on the circuit board and connectable to the input terminal unit, the plurality of pairs of connection terminals comprising two or more pairs of connection terminals connected to a backflow prevention circuit and one pair of connection terminals not connected to the backflow prevention circuit, and a parallel connection circuit configure to connect the plurality of pairs of connection terminals in parallel, in which the backflow prevention circuit is connected between the parallel connection circuit and each of the two or more pairs of connection terminals but not connected between the parallel connection circuit and the one pair of connection terminals.

The electrical device may further include a plurality of pairs of connection terminals disposed on the circuit board and connectable to the input terminal unit, the plurality of pairs of connection terminals comprising two or more pairs of connection terminals and one pair of connection terminals having capacitance larger than capacitance of each of the two or more pairs of connection terminals, and a parallel connection circuit configured to connect the plurality of pairs of connection terminals in parallel.

In the electrical device, at least a portion of the plurality of pairs of connection terminals may be disposed within the second portion of the circuit board. The input terminal unit may include a plurality of input terminals, and the plurality of input terminals may be connected to the two or more pairs of connection terminals, respectively. The input terminal unit may include an input terminal, and the input terminal may be connected to one pair of connection terminals other than the two or more pairs of connection terminals.

In accordance with another aspect of the present invention, there is provided a method for manufacturing an electrical device to which power supplied from a power source is input, the method including disposing a circuit board in a casing, disposing, in the casing, a first electromagnetic shielding plate that electromagnetically shields the circuit board so that the electromagnetic shielding plate can cover a first portion of the circuit board, preparing a second electromagnetic shielding plate that electromagnetically shields the circuit board, the second electromagnetic shielding plate having one surface on which an input terminal unit used to input the power supplied from the power source to the circuit board is provided, and disposing the second electromagnetic shielding plate to cover a second portion of the circuit board in a state in which the other surface of the second electromagnetic shielding plate is arranged to face the circuit board.

The outline of the present invention which is described above does not enumerate all the required features of the present invention. Sub-combinations of groups of these features can also fall within the scope of the present invention.

### BRIEF DESCRIPTION OF THE DRAWINGS

Fig. 1 is an exploded perspective view of a power conditioner according to one embodiment;
Fig. 2 is a diagram illustrating an arrangement of parts built in the power conditioner;
Fig. 3 is a perspective view of an accommodation box with various parts accommodated therein, viewed from a front side;
Fig. 4 is a diagram illustrating a circuitry of an electric circuit disposed on a first circuit board;
Fig. 5 is a perspective view of the first circuit board;
Fig. 6 is a view of the first circuit board viewed from above;
Fig. 7 is a perspective view illustrating a state in which a second electromagnetic shielding plate, to which an input terminal unit including a plurality of input terminals is fixed, is disposed on a front surface side of the first circuit board;
Fig. 8 is a perspective view illustrating a state in which a second electromagnetic shielding plate, to which an input terminal unit induing an input terminal is fixed, is disposed on the front surface of the first circuit board; and
Fig. 9 is a flowchart illustrating an example of the procedure of a method for manufacturing a power conditioner.

### DETAILED DESCRIPTION

ereinaftar, although the present invention will be described with reference to the following embodiments, the following embodiments are not intended to limit the present invention according to the claims. Not all of the combinations of the features which are described in the following embodiments are indispensable to solving means of the present invention.

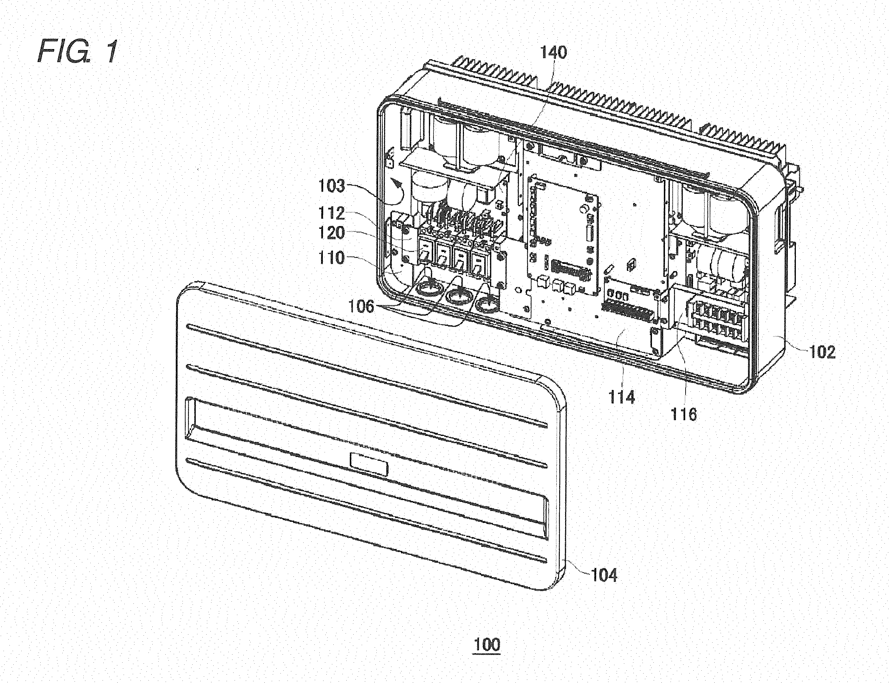

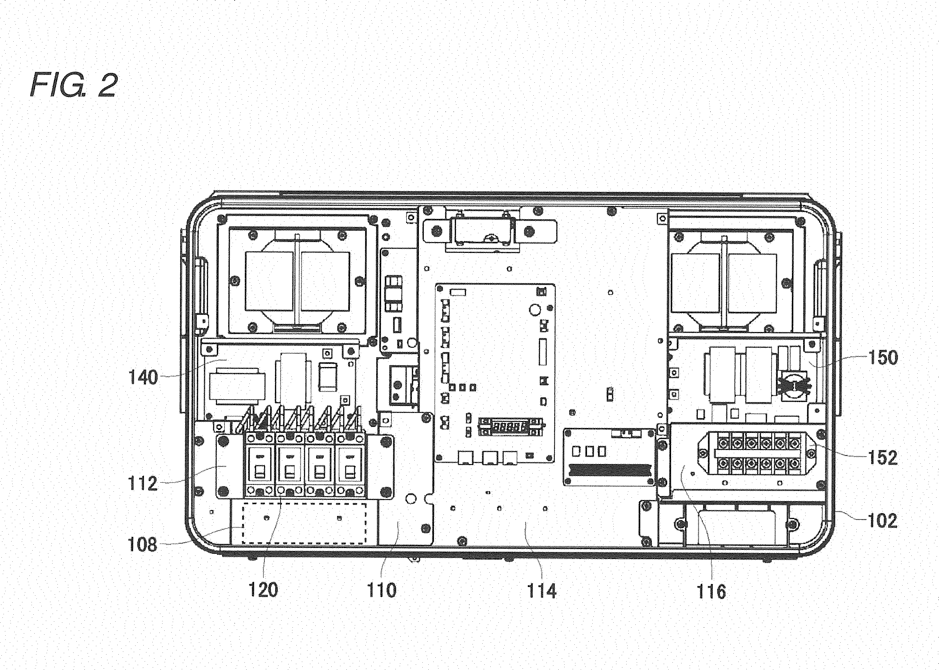

Fig. 1 is an exploded perspective view of a power conditioner 100 according to one embodiment. Fig. 2 is a diagram illustrating an arrangement of parts built in the power conditioner 100. The power conditioner 100 converts direct current (DC) power output from a power source, such as a solar cell or a fuel cell, into alternating current (AC) power. The power conditioner 100 is an example of an electrical device. The power conditioner 100 includes a casing. The casing includes an accommodation box 102 for accommodating various parts therein and a cover 104 for covering an opening formed in the accommodation box 102.

The power conditioner 100 can be used as a junction box built-in power conditioner having a junction box function in which direct current (DC) power output from a plurality of power sources, for example, a plurality of solar cells is connected in parallel. Alternatively, by exchanging the input terminal unit, the power conditioner 100 can be used as a junction box-unmounted power conditioner.

The accommodation box 102 accommodates an input-side filter circuit, an inverter circuit, and an output-side filter circuit therein. The input-side filter circuit reduces noise of the DC power output from the power source. The inverter circuit converts DC power output from the input-side filter circuit into AC power. The output-side filter circuit reduces noise of the AC power output from the inverter. The accommodation box 102 accommodates a circuit board 140 and a circuit board 150. The input-side filter circuit is disposed on the circuit board 140. The output-side filter circuit is disposed on the circuit board 150. The accommodation box 102 accommodates an input terminal unit 120 which is used to input the electric power output from the power source, such as a solar cell, to the circuit board 140. The accommodation box 102 accommodates an output terminal unit 152 which is used to output the AC power from the circuit board 150 to outside.

Electromagnetic shielding plates 110,112, 114, and 116 which electromagnetically shield respective circuit boards, induing the circuit boards 140 and 150, accommodated in the casing are disposed on the cover 104 side of the circuit boards 140 and 150. The electromagnetic shielding plate 110 is provided between the circuit board 140 and a passageway 108 in which a cable for connecting the power source and the input terminal unit 120 is installed. In this manner, the circuit board 140 can be shielded from electromagnetic noise generated from the cable. The cable disposed in the passageway 108 is inserted into the accommodation box 102 through a plurality of insertion holes 106 formed in the bottom of the accommodation box 102.

The inverter circuit is disposed on the back surface side of the electromagnetic shielding plate 114. The input terminal unit 120 is fixed to the front surface of the electromagnetic shielding plate 112, i.e., the cover 104 side. The output terminal unit 152 is fixed to the front surface of the electromagnetic shielding plate 116.

The electromagnetic shielding plates 110,114, and 116 support the casing by being in contact with the inside surface 103 of the casing. The electromagnetic shielding plates 110,114, and 116 are integrally formed as one body in order to support the casing. The electromagnetic shielding plates 110, 114, and 116 may be formed from a single sheet of electromagnetic shielding plate.

When the electromagnetic shielding plates 110 and 112 are formed from a single sheet of electromagnetic shielding plate, in a state in which the single sheet of electromagnetic shielding plate is removed, a portion of the inside surface of the casing cannot be supported by the electromagnetic shielding plate. Therefore, when the electromagnetic shielding plates 110 and 112 are formed from a single sheet of electromagnetic shielding plate, in a state in which the single sheet of electromagnetic shielding plate is removed, the strength of the casing decreases. For this reason, when the casing is carried in a state in which the single sheet of electromagnetic shielding plate is removed, the casing is likely to be deformed. Meanwhile, according to the present embodiment, even in a state in which the electromagnetic shielding plate 112 is not fixed, other electromagnetic shielding plates support the inside surface of the casing. Therefore, the strength of the casing does not decrease. Accordingly, even when the casing is carried in a state in which the electromagnetic shielding plate 112, to which the input terminal unit 120 is fixed, is removed, deformation of the casing can be prevented.

According to the power conditioner 100 according to the present embodiment, for the junction box built-in power conditioner and the junction box-unmounted power conditioner, as many parts as possible can be communalized. Therefore, simplification of work processes and reduction of cost can be achieved.

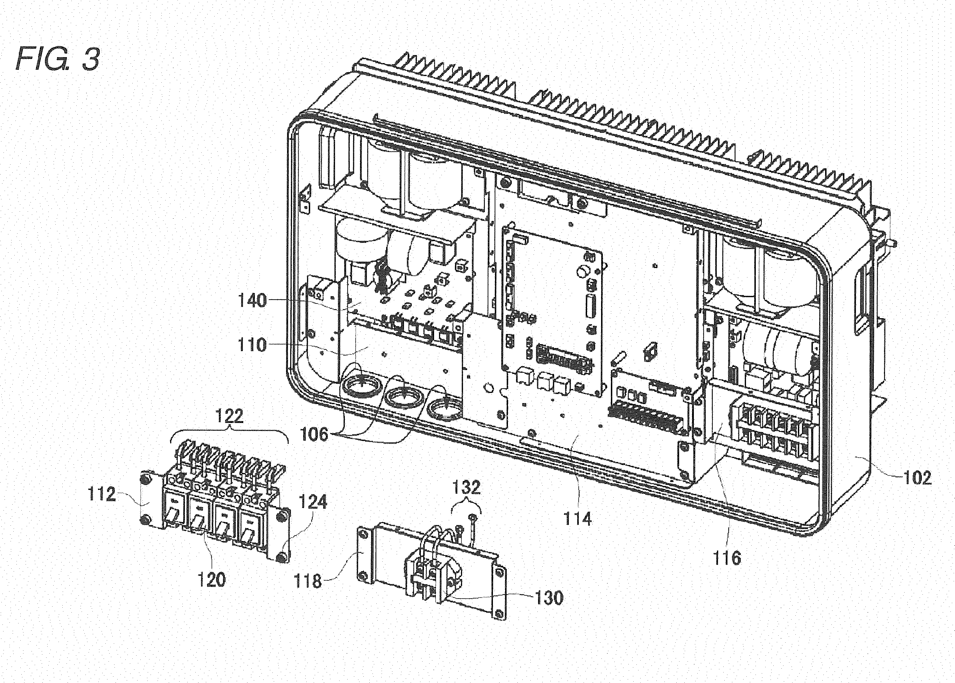

Fig. 3 is a perspective view of the accommodation box 102 viewed from the front side of the accommodation box 102 in which various kinds of common parts which can be used for both of the junction box built-in power conditioner and the junction box-unmounted power conditioner are accommodated.

The electromagnetic shielding plate 112 or 118 is provided to removably attachable to the casing independently of the electromagnetic shielding plate 110. The electromagnetic shielding plate 112; to which, as an input terminal unit, the input terminal unit 120 including a plurality of input terminals is fixed, can be fixed to the electromagnetic shielding plate 110: With this configuration, the power conditioner 100 can be used as the junction box built-in power conditioner having a junction box function in which DC power output from a plurality of power sources, for example, a plurality of solar cells is connected in parallel.

On the other hand, the electromagnetic shielding plate 118, to which, as an input terminal unit, the input terminal unit 130 incliading an input terminal is fixed, can be fixed to the electromagnetic shielding plate 110. Instead of the electromagnetic shielding plate 112, the electromagnetic shielding plate 118 can be fixed to the electromagnetic shielding plate 110. The input terminal unit 130 can be electrically connected to the junction box via a pair of cables. In this way, the power conditioner 100 can be used as the junction box-unmounted power conditioner.

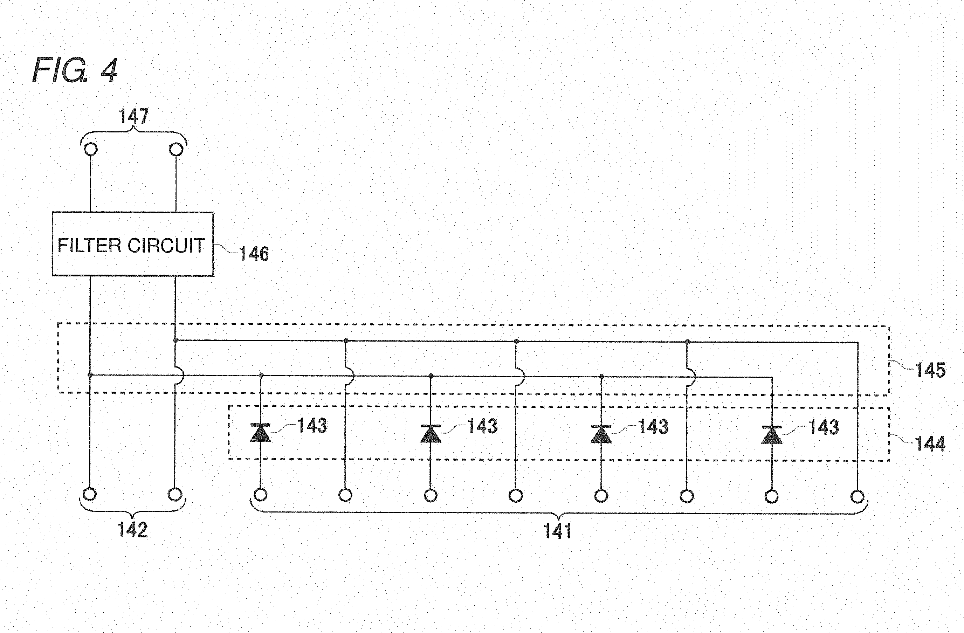

Fig. 4 is a diagram illustrating a circuitry of an electric circuit disposed on the first circuit board 140. A plurality of pairs of connection terminals 141 connectable to the input terminal unit 120, a pair of connection terminals 142 connectable to the input terminal unit 130, and a pair of connection terminals 147 are disposed on the circuit board 140. A parallel connection circuit 145 for connecting the plurality of pairs of connection terminals 141 and the pair of connection terminals 142 in parallel is electrically connected to the plurality of pairs of connection terminals 141 and the pair of connection terminals 142.

A backflow prevention circuit 144 is connected between the parallel connection circuit 145 and the plurality of pairs of connection terminals 141. The backflow prevention circuit 144 includes a plurality of backflow prevention diodes 143 connected to the plurality of pairs of connection terminals 141. However, the backflow prevention circuit 144 is not connected between the parallel connection circuit 145 and the pair of connection terminals 142. The input-side filter circuit 146 is connected between the parallel connection circuit 145 and the pair of connection terminals 147. The pair of connection terminals 147 is connected to the inverter circuit via the pair of cables.

Here, the DC power output from a plurality of power sources, such as a plurality of solar cells, is collectively input to the pair of connection terminals 142 via the junction box. On the other hand, the DC power output from each of a plurality of power sources, such as a plurality of solar cells, is individually input to the plurality of pairs of connection terminals 141. Therefore, capacitance (terminal capacitance) of each of the plurality of pairs of connection terminals 141 is set to be smaller than capacitance of the pair of connection terminals 142.

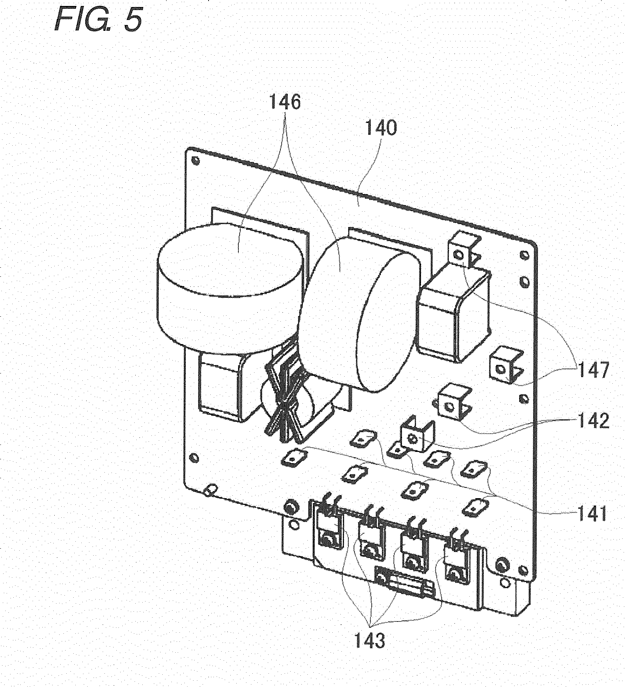

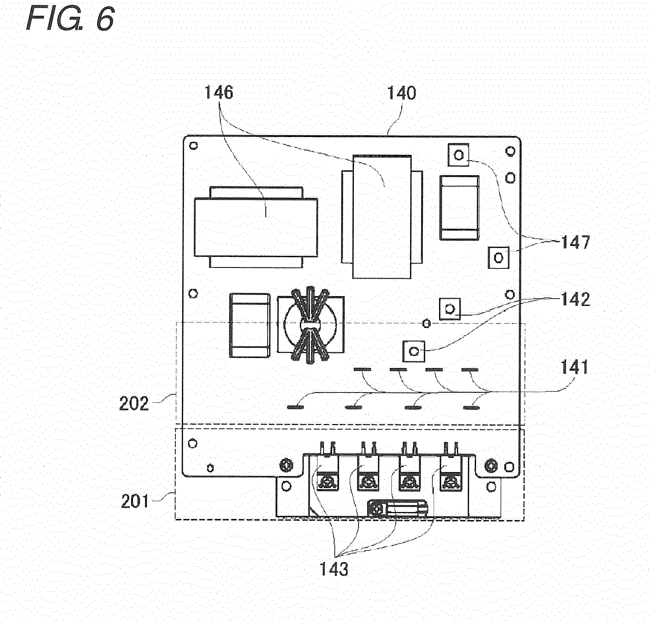

Fig. 5 is a perspective view of the circuit board 140 viewed from the front surface side, i.e., from the cover side. Fig. 6 is a plan view of the circuit board 140 viewed from the front surface side. The electromagnetic shielding plate 110 is disposed in a manner of covering the upper part of a first portion 201 of the circuit board 140. That is, the electromagnetic shielding plate 110 is disposed to cover the upper part of the backflow prevention diodes 143 arranged along a horizontal direction in a state in which the power conditioner 100 is installed. The electromagnetic shielding plate 112 or 118 is disposed to cover the upper part of a second portion 202 of the circuit board 140.

The plurality of pairs of connection terminals 141 and at least a portion of the pair of connection terminals 142 are disposed within the second portion 202 of the first circuit board. In a state in which the electromagnetic shielding plate 112 or 118 is not fixed to the electromagnetic shielding plate 110, the upper part of the plurality of pairs of connection terminals 141 and the upper part of the pair of connection terminals 142 are not covered by any of the electromagnetic shielding plates. Therefore, in the state in which the electromagnetic shielding plate 110 is fixed to the casing, even when the plurality of pairs of connection terminals 141 and the pair of connection terminals 142 are connected to the input terminal unit 120 or 130 via cables, the electromagnetic shielding plate 110 does not serve as a barrier which makes it difficult to perform a work process of connecting the cables. Accordingly, a user can easily perform the work process of fixing the electromagnetic shielding plate 112 or 118, to which the input terminal unit 120 or 130 is fixed, to the electromagnetic shielding plate 110 after the input terminal unit 120 or 130 is connected to the plurality of pairs of connection terminals 141 or the pair of connection terminals 142 via the cables.

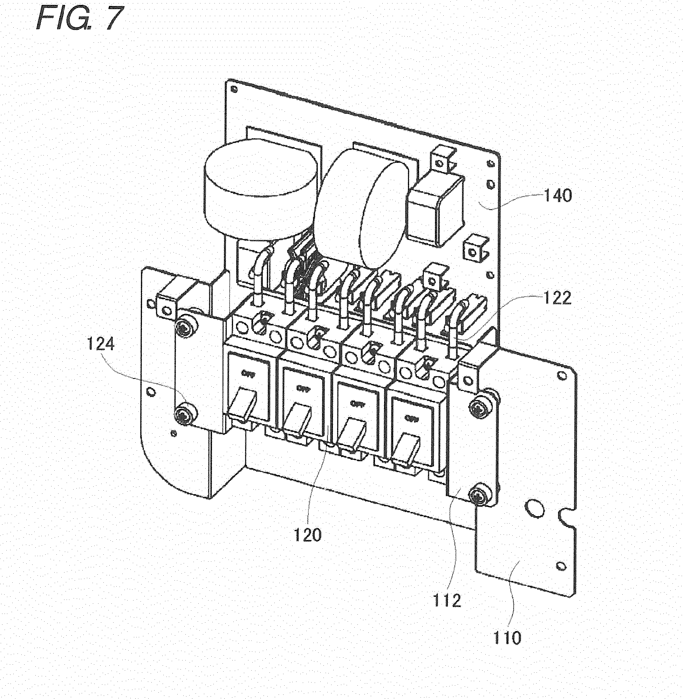

Fig. 7 is a perspective view illustrating a state in which the electromagnetic shielding plate 112, to which the input terminal unit 120 including a plurality of input terminals is fixed, is disposed on the front surface side of the circuit board 140. The electromagnetic shielding plate 110 and the electromagnetic shielding plate 112 may insulate the input terminal unit 120 including a plurality of input terminals from the circuit board 140 by being fixed by insulating bolts 124.

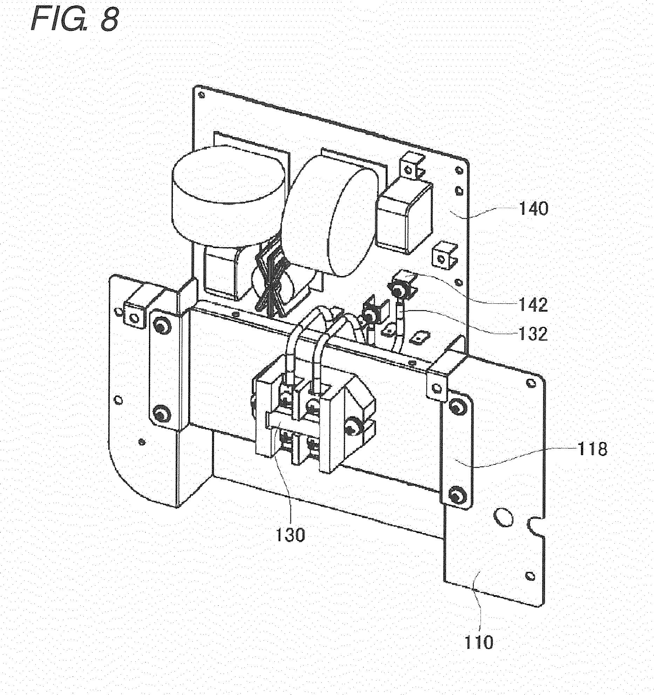

Fig. 8 is a perspective view illustrating a state in which the electromagnetic shielding plate 118, to which the input terminal unit 130 including an input terminal is fixed, is disposed on the front surface of the circuit board 140. A pair of cables 132 is connected between the input terminal unit 130 and the pair of connection terminals 142.

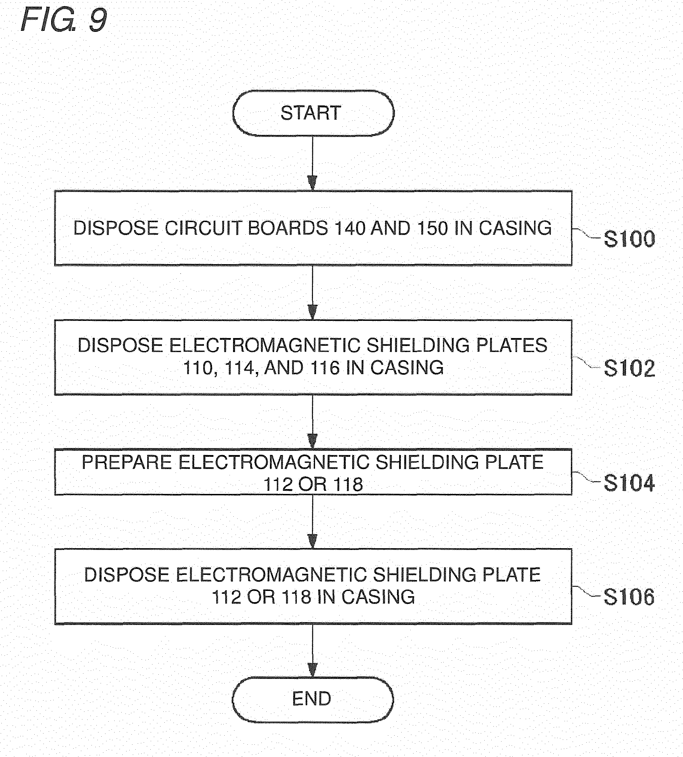

Fig. 9 is a flowchart illustrating an example of the procedure of a method for manufacturing the power conditioner 100 according to the present embodiment.

Various circuit boards including the circuit board 140 and the circuit board 150 are disposed inside the casing in Step S100. The various circuit boards may be common circuit boards that can be used for both of the junction box built-in power conditioner and the junction box-unmounted power conditioner. Subsequently, the electromagnetic shielding plate 110, the electromagnetic shielding plate 114, and the electromagnetic shielding plate 116 are disposed in the casing so that the various circuit boards are covered by the electromagnetic shielding plates 110, 114, and 116 and the electromagnetic shielding plates 110, 114, and 116 are fixed to the casing by being brought into contact with the inside surfaces of the casing. The electromagnetic shielding plate 110 is disposed, in Step S102, so as to cover the first portion 201 in which the backflow prevention diode 143 on the circuit board 140 is disposed.

Subsequently, the electromagnetic shielding plate 112 with the input terminal unit 120 provided on one surface thereof or the electromagnetic shielding plate 118 with the input terminal unit 130 provided on one surface thereof is prepared in Step S104. The cables to be connected to the plurality of pairs of connection terminals 141 or the pair of connection terminals 142 provided on the circuit board 140 are connected to the input terminal unit 120 or the input terminal unit 130.

The cables which are connected to the input terminal unit 120 or the input terminal unit 130 are connected to the plurality of pairs of connection terminals 141 or the pair of connection terminals 142 provided on the circuit board 140. More specifically, the plurality of input terminals of the input terminal unit 120 is connected to the plurality of pairs of connection terminals 141 via a plurality of pairs of cables 122. Alternatively, one input terminal of the input terminal unit 130 is connected to the pair of connection terminals 142 via the pair of cables 132. Subsequently, the other surface of the electromagnetic shielding plate 112 or the electromagnetic shielding plate 118 is made to face the front surface of the circuit board 140, and the electromagnetic shielding plate 112 or the electromagnetic shielding plate 118 is disposed in the casing so that second portion 202 of the first circuit board can be covered in Step S106. Yet alternatively, the electromagnetic shielding plate 112 or the electromagnetic shielding plate 118 may be fixed to the same position in the electromagnetic shielding plate 110.

According to the method for manufacturing the power conditioner 100 according to the present embodiment, processes other than a process of installing the input terminal unit 120 or the input terminal unit 130 may be performed in common for the junction box built-in power conditioner and the junction box-unmounted power conditioner. As many parts as possible can be communalized for the junction box built-in power conditioner and the junction box-unmounted power conditioner. Therefore, simplification of work processes and reduction of cost can be achieved.

As for the casing, in the state in which either the electromagnetic shielding plate 112 or the electromagnetic shielding plate 118, to which the input terminal unit 120 or the input terminal unit 130 is fixed, is not disposed in the casing, each inside surface of the casing is supported by the other electromagnetic shielding plate. Therefore, when the casing in which the electromagnetic shielding plate 112 or the electromagnetic shielding plate 118 is not disposed is carried, deformation of the casing can be prevented.

Furthermore, even when each inside surface of the casing is supported by the other electromagnetic shielding plate, the connection terminals 141 and 142 on the circuit board 140 connected to the cables 122 or the cables 132 which are connected to the input terminal unit 120 or the input terminal unit 130 are not covered by the other electromagnetic shielding plate. Therefore, even in the state in which common parts other than the electromagnetic shielding plate 112 or the electromagnetic shielding plate 118, to which the input terminal unit 120 or the input terminal unit 130 is fixed, are accommodated in the casing, the work of connecting the connection terminals 141 or the connection terminal 142 on the circuit board 140 to the cables can be easily performed.

Although the present invention has been described with reference to the embodiments, the technical scope of the present invention is not limited to the range described in the above embodiments. It is apparent to those skilled in the art that various changes or alterations to the above-described embodiments are possible. It is apparent that embodiments obtained by changing or altering the above-described embodiments also fall within the technical scope of the present invention.

It should be noted that execution order of each process, operation, sequence, or step in a device, a system, a program, and a method stated in claims, specification, and drawings is arbitrary as long as the expressions "before that", "previously", etc. are not explicitly stated and as long as an output of a preceding step is used in the subsequent steps. As for an operation flowchart in claims, specification, and drawings, although a description therein is made with the expressions "first", "next", etc. for convenience, it is not intended that steps should be performed necessarily in the order described.

## Claims

1. An electrical device to which power supplied from a power source is input,
the electrical device comprising:
a casing;
a circuit board (140) disposed inside the casing;
a first electromagnetic shielding plate (110) configured to electromagnetically shield the circuit board (140) by covering a first portion (201) of the circuit board (140);
a second electromagnetic shielding plate (112, 118) configured to electromagnetically shield the circuit board (140) by covering a second portion (202) of the circuit board (140) and be removably attachable to the casing independently of the first electromagnetic shielding plate (110); and
an input terminal unit (120, 130) configured to input the power supplied from the power source to the circuit board (140), the input terminal unit (120, 130) being fixed to a front surface of the second electromagnetic shielding plate (112,118), the front surface of the second electromagnetic shielding plate (112, 118) being a surface facing a front side of the casing.

2. The electrical device according to claim 1, wherein
the first electromagnetic shielding plate (110) is configured to support the casing by being in contact with an inside surface of the casing.

3. The electrical device according to claim 1 or 2, wherein
the first electromagnetic shielding plate (110) is provided between the circuit board (140) and a passageway (108) in which a cable for connecting the power source and the input terminal unit (120, 130) to each other is installed.

4. The electrical device according to any one of claims 1 to 3, further comprising:
a plurality of pairs of connection terminals (141, 142) disposed on the circuit board (140) and connectable to the input terminal unit (120, 130), the plurality of pairs of connection terminals (141, 142) comprising two or more pairs of conneetion terminals (141) connected to a backflow prevention circuit (144) and one pair of connection terminals (142) not connected to the backflow prevention circuit (144); and
a parallel connection circuit (145) configured to connect the plurality of pairs of connection terminals (141, 142) in parallel, wherein
the backflow prevention circuit (144) is connected between the parallel connection circuit (145) and each of the two or more pairs of connection terminals (141), and
the backflow prevention circuit (144) is not connected between the parallel connection circuit (145) and the one pair of connection terminals (142).

5. The electrical device according to any one of claims 1 to 3, further comprising:
a plurality of pairs of connection terminals (141, 142) disposed on the circuit board (140) and connectable to the input terminal unit (120, 130), the plurality of pairs of connection terminals (141, 142) comprising two or more pairs of connection terminals (141) and one pair of connection terminals (142) having capacitance larger than capacitance of each of the two or more pairs of connection terminals (141); and
a parallel connection circuit (145) configured to connect the plurality of pairs of connection terminals (141, 142) in parallel.

6. The electrical device according to claim 4 or 5, wherein
at least a portion of the plurality of pairs of connection terminals (141, 142) is disposed within the second portion (202) of the circuit board (140).

7. The electrical device according to any one of claims 4 to 6, wherein
the input terminal unit (120) comprises a plurality of input terminals, and the plurality of input terminals are connected to the two or more pairs of connection terminals, respectively.

8. The electrical device according to any one of claims 4 to 6, wherein
the input terminal unit (130) comprises an input terminal, and
the input terminal is connected to the one pair of connection terminals.

9. A method for manufacturing an electrical device to which power supplied from a power source is input,
the method comprising:
disposing a circuit board (140) in a casing;
disposing, in the casing, a first electromagnetic shielding plate (110) that electromagnetically shields the circuit board (140) so that the first electromagnetic shielding plate (110) covers a first portion (201) of the circuit board (140);
preparing a second electromagnetic shielding plate (112, 118) that electromagnetically shields the circuit board (140), the second electromagnetic shielding plate (112, 118) having one surface on which an input terminal unit (120, 130) used to input the power supplied from the power source to the circuit board (140) is provided; and
disposing the second electromagnetic shielding plate (112, 118) in the casing so as to cover a second portion (202) of the circuit board (140) in a state in which the other surface of the second electromagnetic shielding plate (112, 118) is arranged to face the circuit board (140).
